# EUROPÄISCHE PATENTANMELDUNG

(11) **EP 1 592 043 A2**
(43) Veröffentlichungstag der Anmeldung: **02.11.2005**
(21) Anmeldenummer: 05009344.2
(22) Anmeldetag: 28.04.2005
(51) Int. Cl.: H01L 21/00

(54) **Druckmessvorrichtung für Vakuumanlagen**

(30) Priorität: 28.04.2004 DE 102004020915
(71) Anmelder: centrotherm Photovoltaics GmbH + Co. KG, 89143 Blaubeuren (DE)
(72) Erfinder: Völk, Hans-Peter, Dipl-Ing., 89608 Griesingen (DE); Wanka, Harald, Dr., 89143 Blaustein (DE); Reichart, Hans, 89134 Blaubeuren (DE)
(74) Vertreter: Lippert, Stachow & Partner

(57) **Zusammenfassung**

Die Erfindung betrifft eine Druckmessvorrichtung für Vakuumanlagen zur Oberflächenbeschichtung oder -modifikation von Gegenständen bzw. Substraten in einem Innenrezipienten innerhalb einer Prozesskammer. Der Erfindung liegt die Aufgabe zugrunde, eine Druckmessvorrichtung für Vakuumanlagen zur oberflächenbeschichtung oder -modifikation von Gegenständen bzw. Substraten zu schaffen, mit der eine kontinuierliche und sichere Bestimmung des Druckes im Innenrezipienten ermöglicht wird. Erreicht wird das dadurch, dass der Innenrezipient (2) in der Prozesskammer (4) zumindest teilweise definiert elastisch ausgeführt ist und dass dem elastischen Bereich (1) des Innenrezipienten (2) eine Messeinrichtung in Form einer Abstandsmesseinrichtung (3) zur Messung der Verformung des elastischen Bereiches (1) zugeordnet ist.

## Beschreibung

Die Erfindung betrifft eine Druckmessvorrichtung für Vakuumanlagen zur Oberflächenbeschichtung oder Oberflächenmodifikation von Gegenständen bzw. Substraten in einem Innenrezipienten innerhalb einer Prozesskammer.

Üblicher Weise kommen Beschichtungs- oder Bedampfungsreaktoren in einer Prozesskammer, beispielsweise in der Halbleitertechnik zur Beschichtung von wafern oder anderen Halbleiterstrukturen und sonstigen Substraten zum Einsatz, indem die Substrate, z.B. wafer nach dem Einbringen in den Innenrezipienten in der Prozesskammer ein für das nachfolgende Bearbeitungsverfahren geeigneter Druck durch eine Vakuumpumpe erzeugt wird. Der Innenrezipient umschließt den Reaktionsraum.

Sobald nach dem Einbringen des zu bearbeitenden Gutes der für den jeweiligen Beschichtungs- oder Bedampfungsprozess jeweils erforderliche Druck im Innerezipienten erreicht worden ist, wird der entsprechende Prozess gestartet.

Nach der Bearbeitung der Substrate im Innenrezipienten wird in diesem der normale Umgebungsdruck eingestellt, so dass dieser geöffnet und das bearbeitete Substrat entnommen werden kann.

Bei den beschriebenen Prozessen, die in Vakuumanlagen mit sogenannten Innenrezipienten durchgeführt werden, in denen das eigentliche zu bearbeitende Gut bzw. Substrat liegt, stellt die Prozesskontrolle ein erhebliches Problem dar.

Die Innenrezipienten sind zum Beispiel erforderlich, wenn die Reaktorkammer von der eigentlichen Reaktion im Reaktionsraum im Innenrezipienten geschützt werden muss, oder umgekehrt.

Erfordert die Trennung auch eine gastechnische Abschirmung, werden sich zwangsläufig unterschiedliche Druckverhältnisse einstellen. In solch einem Fall ist eine Druckmessung und somit eine gesteuerte Prozesskontrolle zum Beispiel durch Temperatureinwirkung nicht möglich. Der Grund hierfür liegt darin, dass der Einbau einer Druckmessröhre in den Innenrezipienten meist wegen einer unerwünschten Wechselwirkung zwischen dem Prozess und herkömmlichen Druckaufnehmern nicht möglich ist, oder wenn der Innenrezipient zusammen mit den Substraten innerhalb der Prozesskammer verfahren werden muss.

Der Erfindung liegt daher die Aufgabe zugrunde, eine Druckmessvorrichtung für Vakuumanlagen zur Oberflächenbeschichtung oder -modifikation von Gegenständen bzw. Substraten zu schaffen, mit der eine kontinuierliche und sichere Bestimmung des Differenzdruckes zwischen Innenrezipient und Prozesskammer und des Druckes im Innenrezipienten ermöglicht wird.

Die der Erfindung zugrunde liegende Aufgabe wird dadurch gelöst, dass der Innenrezipient zumindest teilweise definiert elastisch ausgeführt ist und dass dem elastischen Bereich des Innenrezipienten eine Messeinrichtung zur Messung der Verformung des elastischen Bereiches zugeordnet ist.

Die Messung der Verformung des elastischen Bereiches kann bevorzugt durch Abstandsmessung, beispielsweise mit einem Laser erfolgen

Eine einfache Variante der Verformungsmessung besteht darin, die Bewegung des elastischen Bereiches mit einem anderen üblichen Verfahren zur Messung, wie zum Beispiel einem Taster oder einem kapazitiven bzw, induktiven Sensor zu messen.

Stellen sich unterschiedliche Druckverhältnisse im Reaktionsraum (im Innenrezipienten) und der äußeren vakuumkammer ein, kann aus der Verformung der Differenzdruck zwischen Außen- und Innenkammer exakt berechnet werden.

Im Außenraum kann der Druck durch üblicher Druckmesseinrichtungen bestimmt werden und somit ist auch der bis dahin nicht zugängliche Druck im Innenrezipienten bekannt.

Die Erfindung soll nachfolgend an einem Ausführungsbeispiel näher erläutert werden. In den zugehörigen Zeichnungsfiguren zeigen:
- Fig. 1:: einen schematisch dargestellten Innenrezipienten in einer Prozesskammer mit erhöhtem Innendruck gegenüber der Prozesskammer;
- Fig. 2:: einen schematisch dargestellten Innenrezipienten bei Druckausgleich; und
- Fig. 3:: einen schematisch dargestellten Innenrezipienten mit geringerem Innendruck gegenüber der Prozesskammer.

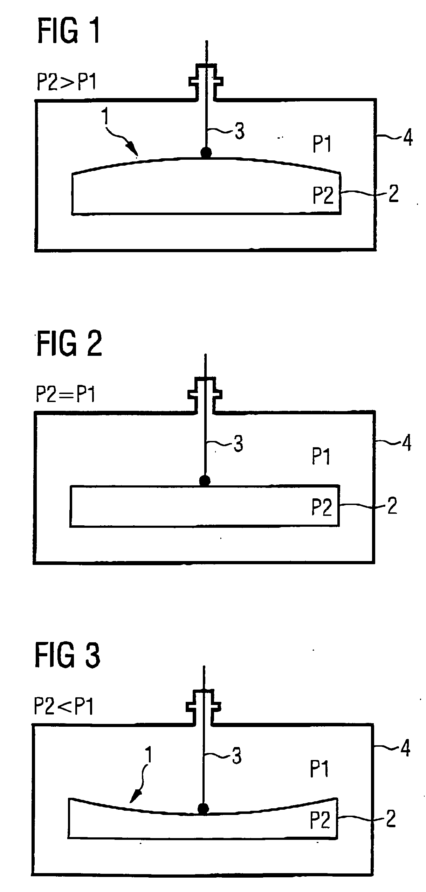

Stellen sich unterschiedliche Druckverhältnisse im Innenrezipienten 2 und der diesen umgebenden Prozesskammer 4 ein (Fig. 1 bis 3) und verfügt der Innenrezipient 2 über einen elastischen Bereich 1, kann aus der verformung des elastischen Bereiches 1 der Differenzdruck zwischen der Prozesskammer 4 und dem Innenrezipienten 2 exakt bestimmt werden.

In der Prozesskammer 4 kann der aktuelle Druck mittels gängiger Druckmesseinrichtungen bestimmt werden und somit ist dann auch der nicht direkt messbare Innendruck im Innenrezipienten 2 bekannt.

Die verformungsmessung des elastischen Bereiches 1 erfolgt mit Hilfe einer Abstandsmesseinrichtung 3 mit einem Laser oder auch mit einem mechanischen Taster bzw. einem kapazitiven oder induktiven Sensor.

### Bezugszeichenliste

- 1: elastischer Bereich
- 2: Innenrezipient
- 3: Abstandsmesseinrichtung
- 4: Prozesskammer

## Patentansprüche

1. Druckmessvorrichtung für Vakuumanlagen zur Oberflächenbeschichtung oder -modifikation von Gegenständen bzw. Substraten in einem Innenrezipienten innerhalb einer Prozesskammer, **dadurch gekenn-zeichnet, dass** der Innenrezipient (2) in der Prozesskammer (4) zumindest teilweise definiert elastisch ausgeführt ist und dass dem elastischen Bereich (1) des Innenrezipienten (2) eine Messeinrichtung zur Messung der verformung des elastischen Bereiches (1) zugeordnet ist.

2. Druckmesseinrichtung nach Anspruch 1, **dadurch gekennzeichnet, dass** für die Messung der Verformung des elastischen Bereiches (1) eine Abstandsmesseinrichtung (3) vorgesehen ist.

3. Druckmesseinrichtung nach Anspruch 2, **dadurch gekennzeichnet, dass** die Abstandsmesseinrichtung (3) mit einem Laser ausgestattet ist.

4. Druckmesseinrichtung nach Anspruch 2, **dadurch gekennzeichnet, dass** die Abstandsmesseinrichtung (3) einen Taster aufweist.

5. Druckmesseinrichtung nach Anspruch 2, **dadurch gekennzeichnet, dass** die Abstandsmesseinrichtung (3) einen kapazitiven oder induktiven Sensor aufweist.

6. Druckmesseinrichtung nach einem der Ansprüche 1 bis 5, **dadurch gekennzeichnet, dass** sich bei unterschiedlichen Druckverhältnisse im Innenrezipienten (2) und der äußeren Prozesskammer (4) der Differenzdruck zwischen Außen- und Innenkammer aus der verformung des elastischen Bereiches (1) bestimmt.

7. Druckmesseinrichtung nach einem der Ansprüche 1 bis 6, **dadurch gekennzeichnet, dass** für die Bestimmung des Druckes in der Prozesskammer (4) übliche Druckmesseinrichtungen, z.B. Druckmessrohre, vorgesehen sind.
